(19) **Europäisches Patentamt / European Patent Office / Office européen des brevets**

(11) **EP 3 495 861 B1**

(12) **FASCICULE DE BREVET EUROPEEN**

(45) Date de publication et mention
de la délivrance du brevet:
**14.09.2022 Bulletin 2022/37**

(21) Numéro de dépôt: **18210428.1**

(22) Date de dépôt: **05.12.2018**

(51) Classification Internationale des Brevets (IPC):
**G02B 6/30** *(2006.01)*  **G02B 6/42** *(2006.01)*
**G02B 6/12** *(2006.01)*  **G02B 6/124** *(2006.01)*
**G02B 6/136** *(2006.01)*  **H01S 5/18** *(2021.01)*

(52) Classification Coopérative des Brevets (CPC):
**G02B 6/124; G02B 6/12004; G02B 6/136;**
**G02B 6/30; G02B 6/4206;** G02B 2006/12147;
H01S 5/0071; H01S 5/187

(54) **PUCE PHOTONIQUE À REPLIEMENT DE TRAJET OPTIQUE ET STRUCTURE DE COLLIMATION INTÉGRÉE**

PHOTONEN-CHIP MIT RÜCKFALTUNG DES LICHTWEGS UND INTEGRIERTER BÜNDELUNGSSTRUKTUR

PHOTONIC CHIP WITH BENDING OPTICAL PATH AND INTEGRATED COLLIMATION STRUCTURE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.12.2017 FR 1761723**

(43) Date de publication de la demande:
**12.06.2019 Bulletin 2019/24**

(73) Titulaire: **Commissariat à l'énergie atomique et aux énergies alternatives**
**75015 Paris (FR)**

(72) Inventeurs:
• **MENEZO, Sylvie**
  **38500 VOIRON (FR)**
• **BOUTAMI, Salim**
  **38100 GRENOBLE (FR)**
• **MOUREY, Bruno**
  **38500 COUBLEVIE (FR)**

(74) Mandataire: **Brevalex**
  **95, rue d'Amsterdam**
  **75378 Paris Cedex 8 (FR)**

(56) Documents cités:
**US-A1- 2002 003 824  US-A1- 2004 165 637**
**US-B1- 8 315 287**

EP 3 495 861 B1

**Description**

**DOMAINE TECHNIQUE**

Le domaine de l'invention est celui de la photonique intégrée sur puce ou circuit intégré. L'invention concerne une puce photonique qui dispose d'entrée(s)/sortie(s), vers/depuis la puce, de faisceaux lumineux présentant une taille de mode élargie pour couplage avec un dispositif extérieur, par exemple avec une autre puce photonique, une fibre optique ou un ensemble de fibres optiques, ou pour réception/émission d'un faisceau de lumière en propagation libre.

**ÉTAT DE LA TECHNIQUE ANTÉRIEURE**

Un circuit photonique intégré (« Photonic Integrated Circuit ») comporte plusieurs composants interconnectés entre eux par des guides d'onde de lumière. Le circuit photonique devant en général communiquer avec le monde extérieur, il est nécessaire de pouvoir injecter/extraire la lumière dans/depuis le circuit sous la forme d'un faisceau lumineux non guidé.

Afin de pouvoir injecter/extraire la lumière vers/depuis un circuit photonique intégré perpendiculairement au plan de la puce, deux types de coupleurs verticaux sont couramment utilisés : les réseaux de couplage surfacique et les solutions par renvoi d'angle en sortie de la puce.

Réseaux de couplage surfacique

Un réseau de couplage surfacique permet, d'une part, d'adapter la taille du mode optique se propageant dans les guides d'onde de la puce photonique à la taille du mode optique se propageant dans les fibres monomodes standards, c'est-à-dire un diamètre de 9.2$\mu$m, et, d'autre part, de passer d'une propagation guidée dans le plan de la puce photonique à une propagation en espace libre quasi-verticale au plan de la puce. Ceci est obtenu en gravant un réseau dans la couche comprenant les guides d'onde. Un tel composant est par exemple décrit dans : « Apodized Waveguide Grating Couplers for Efficient Coupling to Optical Fibers », IEEE PHOTONICS TECHNOLOGY LETTERS, VOL. 22, NO. 15, AUGUST 1, 2010, de Xia Chen et alter.

En technologie silicium, ce composant permet ainsi de coupler la lumière d'un guide d'onde dans le plan de la puce photonique à une fibre monomode clivée faisant un angle avec la verticale, couramment d'environ 8°. Les pertes de ce composant sont de 1 à 4 dB optiques lorsque l'alignement géométrique entre le réseau de couplage surfacique et la fibre monomode est optimal. La tolérance d'alignement réseau-fibre, caractérisée comme le désalignement radial par rapport à l'alignement optimal qui engendre 1 dB de pertes supplémentaires, est d'environ 2 $\mu$m.

Afin d'augmenter la tolérance d'alignement entre un réseau de couplage surfacique et une fibre optique et rendre ainsi les opérations d'alignement moins complexes et notamment réalisables selon des techniques d'alignement passif moins coûteuses, il a été proposé dans l'article de S. Bernabé et al., "On-Board Silicon Photonics-Based Transceivers With 1-Tb/s Capacity", in IEEE Transactions on Components, Packaging and Manufacturing Technology, vol. 6, n°7, Juillet 2016, d'avoir recours à un système de deux lentilles composé d'une première lentille solidaire de la puce photonique (qui permet d'élargir et collimater le faisceau en entrée/sortie de la puce) et d'une deuxième lentille solidaire de la fibre optique. La première lentille doit être alignée avec la puce photonique de manière très précise, puis doit être solidarisée avec elle. La tolérance d'alignement entre l'ensemble puce + première lentille et l'ensemble deuxième lentille + fibre est alors augmentée à +/- 10 à 20 $\mu$m. Afin d'élargir et de collimater un faisceau lumineux de longueur d'onde $\lambda$ et de taille de mode Do=2*wo = 9.2$\mu$m en sortie du réseau de couplage surfacique, la première lentille doit avoir une longueur de focale dans l'air égale à Fair= Di. ( $\pi$. wo/(2$\lambda$)), Di étant la taille du faisceau élargi en sortie de la première lentille. Visant une taille de mode Di de 100$\mu$m, une lentille en verre de silice doit présenter une épaisseur d'environ 860 $\mu$m. Si ce système permet d'assouplir les contraintes d'alignement entre l'ensemble puce + première lentille et l'ensemble fibre + deuxième lentille, il présente l'inconvénient de reporter les contraintes d'alignement entre la première lentille et la puce photonique à une précision inférieure à 1$\mu$m. Par ailleurs, si le fait d'extraire un faisceau collimaté de taille élargie permet d'augmenter la tolérance d'alignement de la puce avec une pièce d'interface opto-mécanique en regard de la face de la puce, la tolérance angulaire de réception est réduite.

Solutions par renvoi d'angle en sortie de la puce

Dans JLT 2016, VOL. 34, NO. 2, JANUARY 15, 2016, Suzuki et al. ont proposé d'utiliser un facettage du guide d'onde à 45° recouvert d'un miroir total pour permettre un renvoi d'un faisceau lumineux perpendiculairement vers la face arrière de la puce photonique. Ce coupleur vertical est dénommé par la suite coupleur par « facettage du guide d'onde ». Au niveau de la face arrière, le faisceau étant très divergent ou inadapté à la taille de mode de la fibre, il est proposé d'intégrer une lentille sur la face arrière de la puce. Dans cette implémentation, l'épaisseur traversée par le faisceau, entre le guide facetté et la lentille en face arrière, est d'environ 100μm ce qui représente la focale potentielle de la lentille. Cette lentille présente une surface dont l'épaisseur varie continûment. Le profil de cette surface est ainsi qualifié d'analogique. La fabrication d'un tel profil analogique par gravure exploite une technique de lithographie par fluage de résine ou par lithographie dite « Gray tone » qui présente l'inconvénient d'être difficile à calibrer pour obtenir les formes analogiques souhaitées. De telles lentilles doivent par ailleurs être recouvertes de couches antireflet, du fait des réflexions de Fresnel à l'interface entre la lentille (indice = 3.5) et l'air (indice = 1). Or les traitements antireflet sont notamment fragiles en milieu chaud / humide (85°C/ 85% d'humidité), ce qui nécessite d'avoir recours à un conditionnement hermétique.

Un autre exemple d'intégration d'une lentille à une puce photonique sur le chemin du faisceau depuis/vers un coupleur vertical est donné dans le brevet US 8,515,217 B2.

Dans une première variante de ce brevet, la lentille est positionnée en face avant de la puce, en regard d'un réseau de couplage surfacique qui émet en direction de la face avant. En étant intégrée en face avant, la lentille a ainsi une focale potentiellement égale à la distance entre la lentille et le réseau de couplage surfacique. Pour que cette lentille soit intégrée à la puce photonique et qu'elle ne soit pas rapportée avec la contrainte d'alignement précédemment décrite, la lentille doit être réalisée dans la couche d'encapsulation traversée par le faisceau sur le chemin coupleur/lentille, laquelle n'est généralement que de quelques microns. Or une épaisseur de plus de 400 μm de SiO$_2$ serait nécessaire pour passer d'une taille de mode en sortie du coupleur de 9.2 μm à une taille de mode en sortie de la lentille de 55μm. Cette variante ne permet donc pas de fournir un faisceau de taille de mode élargie. Par ailleurs, la fabrication de la lentille en face avant présente l'inconvénient de nécessiter des étapes de fabrication supplémentaires après fabrication de la puce photonique, au-dessus de la puce photonique alors que le dessus de la puce photonique contient généralement des lignes de métal d'interconnexion des composants photoniques avec des circuits électroniques externes.

Dans une deuxième variante de ce brevet, la lentille est positionnée en face arrière, en regard d'un guide d'onde se terminant par une facette inclinée recouverte d'un miroir (dénommé « guide d'onde facetté » par la suite), et orientant le faisceau vers la face arrière de la puce. Cette implémentation et ses limitations ont été décrites plus haut.

Dans une troisième variante de ce brevet, la lentille est positionnée dans la couche comprenant les guides d'onde. Aucune implémentation pratique de cette variante n'est néanmoins décrite, et notamment aucune implémentation permettant d'élargir la taille de mode du faisceau en sortie d'un coupleur vertical.

Les lentilles utilisées dans le brevet US 8,515,217 B2 sont des lentilles analogiques dites de Fresnel. Une lentille de Fresnel remplace la surface courbée d'une lentille conventionnelle par une série d'anneaux concentriques de sections prismatiques différentes d'un anneau à l'autre. L'épaisseur d'une lentille de Fresnel est donc diminuée par rapport à une lentille conventionnelle, mais sa fabrication reste difficile. Elle nécessite une structuration analogique en dents de scie, permettant de définir des crêtes d'inclinaisons variables, généralement réalisée par le technique de lithographie « Gray tone ». Une telle lentille de Fresnel reste par ailleurs sensible aux réflexions de Fresnel. Enfin, une telle lentille est sensible à la polarisation de la lumière du fait des anneaux. En effet, le champ électrique de l'onde optique peut prendre n'importe quelle orientation dans le plan de la puce et les indices vus par l'onde, à l'échelle de la longueur d'onde, diffèrent suivant l'orientation du champ électrique.

US 2002/003824 A1 divulgue une puce photonique équipée d'un laser qui émet dans une couche de guidage de la lumière en direction d'un guide d'onde facetté qui va renvoyer la lumière vers la face arrière de la puce. La face arrière dispose d'une structure réfléchissante qui renvoie la lumière vers la face avant de la puce. Une lentille est formée sur la face avant de la puce.

## EXPOSÉ DE L'INVENTION

L'invention a pour objectif de doter une puce photonique de moyens aptes à collimater et élargir un faisceau optique en sortie de la puce photonique (et réciproquement à focaliser et adapter un faisceau optique en entrée de la puce photonique à une structure de couplage vertical de la puce photonique). Et l'invention cherche à simplifier la fabrication d'une telle puce, pour notamment passer outre les inconvénients de fabrication mentionnés précédemment (profil analogique, traitement anti reflet).

L'invention a également pour objectif de résoudre la problématique de sensibilité de l'alignement angulaire entre la puce de laquelle est extrait un faisceau collimaté de taille élargie et la pièce d'interface opto-mécanique en regard de la face de la puce.

L'invention propose à cet effet une puce photonique comprenant une couche de guidage de la lumière supportée par un substrat et recouverte par une couche d'encapsulation, la puce photonique présentant une face avant du côté de la couche d'encapsulation et une face arrière du côté du substrat. La couche de guidage de la lumière inclue une structure de guidage de la lumière comprenant un guide d'onde et optiquement couplée à un coupleur vertical configuré pour recevoir de la lumière depuis le guide d'onde et former un faisceau de lumière dirigé vers l'une des faces avant et arrière.

La puce photonique comporte en outre une structure de collimation formée au moins en partie dans la couche de guidage de la lumière, ainsi qu'un agencement d'une ou plusieurs structures réfléchissantes chacune sur l'une des faces avant et arrière, ledit agencement étant réalisé de manière à assurer la propagation de la lumière entre le coupleur vertical et la structure de collimation selon un trajet optique présentant au moins un repliement.

Le repliement du trajet optique rallonge la focale de la structure de collimation de telle manière qu'elle peut élargir de manière satisfaisante le diamètre du faisceau optique. Par ailleurs, la structure de collimation intégrée au moins en partie dans la couche de guidage de la lumière peut présenter un profil numérique qui peut être obtenu au moyen de procédés de fabrication standards utilisés pour la structuration des composants de la couche de guidage de la lumière.

Certains aspects préférés mais non limitatifs de cette puce photonique sont définis dans les revendications 2-10. L'invention s'étend à un procédé de fabrication d'une telle puce photonique.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- les figures 1 à 4 sont des couches schématiques de puces photoniques conformes à différentes variantes de réalisation de l'invention ;
- les figures 5a, 5b et 5c sont des schémas de lentilles réalisées par gravure selon des modes de gravure appelés respectivement numérique (figure 5a) et analogique (figures 5b et 5c) dans l'exposé de l'invention ;
- les figures 6a et 6b illustrent différentes variantes de réalisation d'une structure de collimation pouvant être intégrée dans une puce selon l'invention ;
- les figures 7a et 7b illustrent le dimensionnement d'une structure de collimation symétrique pouvant être intégrée dans une puce selon l'invention ;
- les figures 8a et 8b illustrent le dimensionnement d'une structure de collimation asymétrique pouvant être intégrée dans une puce selon l'invention ;
- les figures 9a et 9b fournissent des exemples de dimensionnement d'une structure de collimation de type Fresnel, la structure de la figure 9a ne redressant pas le faisceau lumineux en sortie de puce et la structure de la figure 9b redressant le faisceau lumineux en sortie de puce.

## EXPOSÉ DÉTAILLÉ DE MODES DE RÉALISATION PARTICULIERS

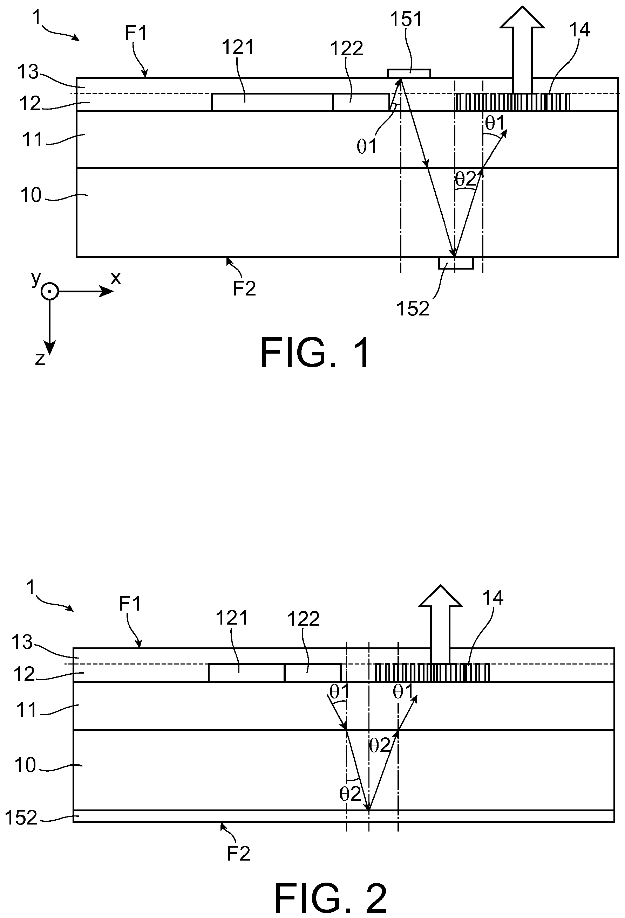

En référence aux figures 1-4, l'invention porte sur une puce photonique 1 qui comprend une couche de guidage de la lumière 12 supportée par un substrat 10 et recouverte par une couche d'encapsulation 13. La couche de guidage de la lumière présente une épaisseur généralement comprise entre 100nm et 3$\mu$m. La couche de guidage de la lumière peut être en silicium, en InP, en GaAs, en Ge, ou en un ou plusieurs matériaux semiconducteurs de type III-V ou IV.

Une couche d'oxyde enterré 11 peut être intercalée entre la couche de guidage de la lumière 12 et le substrat 10. Le substrat peut être en silicium, en phosphure d'indium ou en arséniure de gallium. La couche d'encapsulation 13 peut être une couche en matériau diélectrique, par exemple en oxyde de silicium, en nitrure de silicium, en polymère à base de BCB (benzocyclobutène).

La puce photonique 1 présente une face avant F1 du côté de la couche d'encapsulation 13 et une face arrière F2 du côté du substrat 10. La couche de guidage de la lumière comprend une structure de guidage de la lumière 121 couplée à un coupleur vertical 122 configuré pour recevoir la lumière depuis la structure de guidage de la lumière et former à partir de celle-ci un faisceau de lumière dirigé vers l'une des faces avant et arrière.

Par coupleur vertical, on entend un coupleur permettant de passer d'une propagation guidée dans le plan de la puce (plan (xy) sur la figure 1) à une propagation verticale ou quasi-verticale, formant typiquement un angle inférieur à 90°, et de préférence compris entre 0 et 45°, avec la normale aux faces avant et arrière de la puce (cette normale s'étendant selon la direction z sur la figure 1), par exemple un angle $\theta 1$ de 8° dans une couche d'encapsulation 13 en SiO$_2$. Le coupleur vertical peut être un réseau de couplage surfacique (« grating coupler »). Le coupleur vertical peut également être un coupleur de type guide d'onde facetté.

La structure de guidage de la lumière 121 comprend les différents composants photoniques, passifs ou actifs, jusqu'au coupleur vertical 122. Elle comprend notamment un guide d'onde, ici représenté avec le coupleur vertical 122 selon une coupe longitudinale, la lumière se propageant sur la figure 1 suivant la direction x.

La couche d'encapsulation 13 comprend généralement des niveaux de métal d'interconnexion électrique de la puce photonique. Cette couche est ainsi constituée de matériaux diélectriques et de lignes gravées de métal. Une puce électronique destinée à piloter ou lire les composants photoniques actifs de la puce photonique (modulateurs, photo-détecteurs) est généralement reportée sur la face avant de la puce photonique.

Dans le reste du document, les exemples de calcul sont donnés pour une structure de guidage de la lumière 121 en silicium, une couche d'oxyde enterré 11 en $SiO_2$, et un substrat 10 en silicium.

Pour obtenir en sortie de la puce, à partir d'un réseau de couplage surfacique 122 de taille de mode Do = 9.2$\mu$m, un faisceau collimaté et élargi de diamètre 80 $\mu$m, une lentille en verre de silice doit présenter une épaisseur d'environ 660 $\mu$m. Il en découle que la lentille ne peut pas être intégrée sur la face avant F1 de la puce photonique car le chemin optique entre le réseau de couplage surfacique 122 et la face avant F1 de la puce n'est que de quelques microns de silice (il correspond globalement à l'épaisseur de la couche d'encapsulation 13, par exemple 3 $\mu$m).

Une intégration de la lentille sur la face arrière F2 de la puce, avec un coupleur vertical 122 configuré pour diriger le faisceau de lumière reçu du guide d'onde en direction de la face arrière, n'est pas non plus possible. Dans un tel cas de figure, la longueur du chemin optique entre le coupleur vertical 122 et la face arrière F2 de la puce peut être approximée comme étant l'épaisseur du substrat 10. Pour des substrats de Si, d'InP ou de GaAs, l'indice optique à la longueur d'onde 1.31 $\mu$m est d'environ 3.5, et l'épaisseur nécessaire de matériau pour obtenir un faisceau élargi collimaté de diamètre 80 $\mu$m est de l'ordre de 1550 $\mu$m. Or l'épaisseur du substrat est typiquement de 775$\mu$m+/-25$\mu$m pour un substrat en silicium de 300 mm de diamètre, de 625$\mu$m+/-25$\mu$m pour un substrat en InP de 75mm de diamètre, et de 450$\mu$m pour un substrat de substrat en GaAs de 75mm de diamètre. L'épaisseur du substrat 10 est donc généralement insuffisante pour permettre d'élargir le diamètre du faisceau de manière satisfaisante.

Pour pallier ces difficultés d'intégration de la lentille en face avant ou arrière de la puce photonique, et toujours en référence aux figures 1 à 4, l'invention propose une puce photonique qui est dotée d'un agencement d'une ou plusieurs structures réfléchissantes 151, 152 chacune sur l'une des faces avant et arrière. Cet agencement est réalisé de manière à assurer la propagation de la lumière entre le coupleur vertical 122 et une structure de collimation de la lumière 14 formée au moins en partie dans la couche de guidage de la lumière 12, cette propagation s'effectuant selon un trajet optique présentant au moins un repliement dans le substrat.

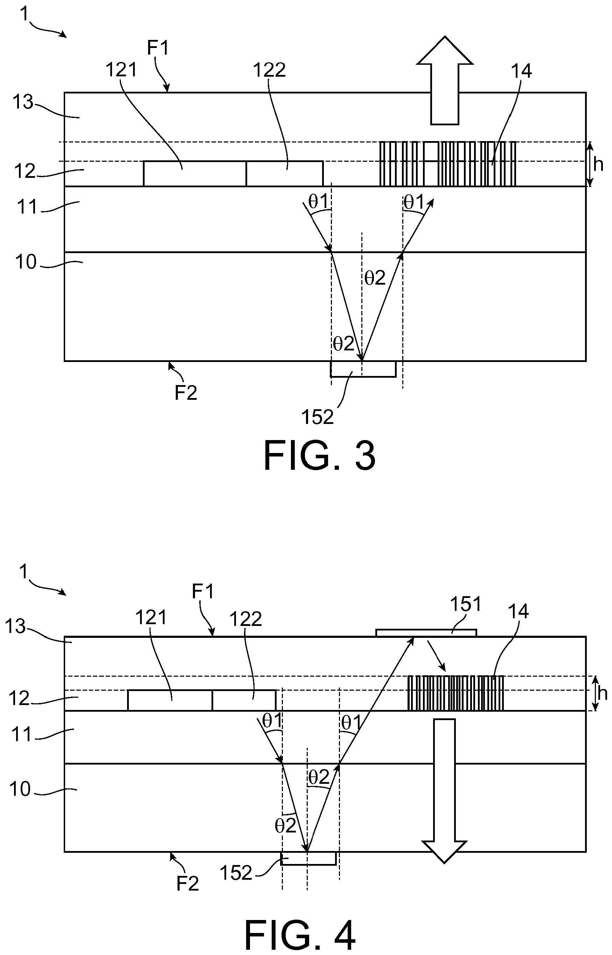

Plus particulièrement, cet agencement comprend une structure réfléchissante 152 en face arrière. De telle manière, que l'extraction de lumière s'opère à travers la face avant (figures 1, 2 et 3) ou à travers la face arrière (figure 4), le trajet optique comprend au moins un double passage par le substrat 10. En rallongeant ainsi la focale, la structure de collimation 14 permet d'élargir de manière satisfaisante le diamètre du faisceau optique.

Dans un mode de réalisation, une structure réfléchissante dudit agencement est une couche métallique déposée sur l'une des faces avant et arrière, par exemple une couche d'or, d'argent ou d'aluminium. Dans une variante de réalisation, une structure réfléchissante dudit agencement est un réflecteur de Bragg distribué (DBR pour « Distributed Bragg Reflector ») formé d'un empilement de couches déposées sur l'une des faces avant et arrière.

Une structure réfléchissante est formée de manière localisée sur l'une des faces avant et arrière de la puce photonique. Alternativement, une structure réfléchissante peut être formée sur la totalité de l'une des faces avant et arrière de la puce photonique, par exemple sur l'intégralité de la face arrière comme représenté dans l'exemple de réalisation de la figure 2.

La description qui suit prend plus particulièrement l'exemple de la transmission de lumière de la structure de guidage de la puce photonique en direction du dispositif extérieur (extraction de lumière), la structure de collimation formant un port de sortie de la lumière. Les principes présentés sont toutefois parfaitement identiques pour une transmission de lumière depuis le dispositif extérieur en direction de la structure de guidage de la puce photonique (injection de lumière), la structure de collimation formant un port d'entrée de lumière. Ainsi, le coupleur vertical 122 est non seulement configuré pour recevoir la lumière depuis la structure de guidage de la lumière et former à partir de celle-ci un faisceau de lumière dirigé vers la face avant F1 ou la face arrière F2 et réfléchi par la ou les structures réfléchissantes jusqu'à atteindre et traverser la structure de collimation 14, mais également configuré pour recevoir depuis la face avant ou la face arrière un faisceau de lumière ayant traversé la structure de collimation et s'étant réfléchi sur la ou les structures réfléchissantes et transférer ce faisceau vers la structure de guidage de la lumière 121.

On a représenté sur les figures 1, 2 et 3 différents exemples d'un premier mode de réalisation dans lequel la lumière est extraite/injectée depuis/vers la puce photonique à travers la face avant F1.

Dans l'exemple de la figure 1, le coupleur vertical 122 est configuré pour recevoir la lumière depuis la structure de guidage de la lumière 121 et former à partir de celle-ci un faisceau de lumière dirigé vers la face avant F1 avec un angle $\Theta$1 par rapport à la verticale. Dans cet exemple, l'agencement d'une ou plusieurs structures réfléchissantes comporte une première structure réfléchissante 151 sur la face avant F1 et une deuxième structure réfléchissante 152 sur la face arrière F2. Le faisceau en sortie du coupleur vertical 122 est réfléchi par la première structure réfléchissante 151 en direction de la deuxième structure réfléchissante 152 puis de la deuxième structure réfléchissante 152 en direction de la structure de collimation 14. Dans cet exemple, le chemin optique du coupleur vertical à la structure de collimation peut être approximé à 2 x T10, où T10 représente l'épaisseur du substrat 10.

Dans les exemples des figures 2 et 3, le coupleur vertical 122 est configuré pour recevoir la lumière depuis la structure de guidage de la lumière 121 et former à partir de celle-ci un faisceau de lumière dirigé vers la face arrière F1 avec un angle $\Theta$1 par rapport à la verticale. Dans cet exemple, l'agencement d'une ou plusieurs structures réfléchissantes comporte une unique structure réfléchissante 152 sur la face arrière F2 (une structure pleine plaque dans le cadre de la figure 2, une structure localisée dans le cadre de la figure 3). Le faisceau en sortie du coupleur vertical 122 est réfléchi par cette unique structure réfléchissante 152 en direction de la structure de collimation 14. Dans la couche d'oxyde enterré 11 en SiO$_2$, l'angle $\Theta$1 est par exemple de 8°. Dans le substrat 10 en silicium, l'angle $\Theta$2 est alors d'environ de 3°. Le chemin optique, CO, du coupleur vertical à la structure de collimation s'écrit rigoureusement comme CO= 2 $\times$ T11 / cos ($\Theta$1) + 2 $\times$ T10 / cos ($\Theta$2), avec T10 l'épaisseur du substrat et T11 l'épaisseur de la couche d'oxyde enterré 11. Ce chemin optique peut être approximé comme 2 $\times$ T10 avec moins de 0,5% d'erreur. En utilisant un coupleur vertical 122 de type réseau de couplage surfacique, et avec un substrat de silicium 10 d'épaisseur T10 = 775 $\mu$m parcouru 2 fois, le diamètre du faisceau en sortie de la structure de collimation peut être élargi jusqu'à environ 80 $\mu$m.

On a représenté sur la figure 4 un exemple d'un second mode de réalisation dans lequel la lumière est extraite/injectée depuis/vers la puce photonique à travers la face arrière F2. Dans cet exemple, le coupleur vertical 122 est configuré pour recevoir la lumière depuis la structure de guidage de la lumière 121 et former à partir de celle-ci un faisceau de lumière dirigé vers la face arrière F1 avec un angle $\Theta$1 dans le SiO2 par rapport à la verticale. L'agencement d'une ou plusieurs structures réfléchissantes comporte une première structure réfléchissante 152 sur la face arrière F2 et une deuxième structure réfléchissante 151 sur la face avant F1. Le faisceau en sortie du coupleur vertical 122 est réfléchi par la première structure réfléchissante 152 en direction de la deuxième structure réfléchissante 151 puis de la deuxième structure réfléchissante 151 en direction de la structure de collimation 14.

Dans un mode de réalisation possible, la couche de guidage de la lumière repose sur une couche en matériau diélectrique, et une couche antireflet est interposée entre le substrat et la couche en matériau diélectrique. On observe effectivement des pertes de Fresnel lors de la traversée de l'interface entre la couche diélectrique 11 et le substrat 10 : elles sont de 0,8 dB avec une couche 11 en SiO$_2$ et un substrat 10 en silicium. Une couche antireflet agencée entre la couche diélectrique 11 et le substrat 10 permet de limiter ces pertes. La couche antireflet est par exemple une couche de nitrure de silicium, d'épaisseur $\lambda$/4 où $\lambda$ correspond à la longueur d'onde du faisceau lumineux. Il est également possible d'adopter pour matériau de la couche 11 non pas du SiO$_2$ mais un nitrure de silicium ou un empilement d'une sous-couche de SiO2 et d'une sous-couche de nitrure de silicium. Les pertes lors de la traversée de l'interface entre la couche 11 et le substrat 10 sont ainsi inférieures à 0.5dB à la longueur d'onde 1.31$\mu$m

Dans le cadre de l'invention, la structure de collimation 14 est formée, au moins en partie, dans la couche de guidage de la lumière 12. L'invention n'a ainsi pas recours à une structure de collimation reportée ou intégrée au niveau de la face avant ou de la face arrière de la puce photonique, ce qui permet de passer outre les contraintes et limitations de fabrication mentionnées précédemment.

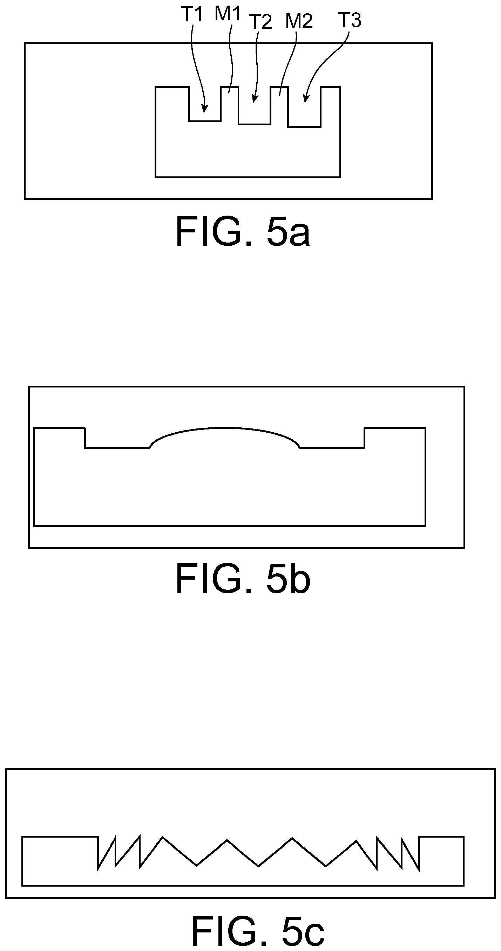

Notamment, la structure de collimation 14 peut être formée lors des étapes de fabrication 'front end' des composants photoniques (guide d'onde, réseau de couplage surfacique, modulateur PN, etc.) par gravure de la couche superficielle 12 d'un substrat SOI. En référence notamment à la figure 5a, la structure de collimation 14 peut ainsi comprendre une pluralité de tranchées T1, T2, T3 pratiquées dans la couche de guidage de la lumière 12, les tranchées délimitant un ensemble de motifs M1, M2 et chaque motif présentant, dans une direction orthogonale aux faces avant et arrière, une épaisseur invariable. Dans un mode de réalisation privilégié, les motifs ont tous la même épaisseur et les tranchées traversent l'épaisseur de la couche de guidage de la lumière 12. L'invention s'étend toutefois à des motifs présentant des épaisseurs différentes, et plus particulièrement à des motifs se répartissant en un premier ensemble de motifs présentant une première épaisseur et un deuxième ensemble de motifs présentant une deuxième épaisseur. La première épaisseur peut être supérieure à la deuxième épaisseur, et les motifs du premier ensemble peuvent être des motifs plus larges que les motifs du second ensemble.

L'épaisseur des motifs est typiquement définie par une profondeur de gravure des tranchées. L'épaisseur d'un motif peut être inférieure, égale voire supérieure à l'épaisseur du guide d'onde 121 de la couche de guidage de la lumière (égale à l'épaisseur du guide d'onde sur les figures 1 et 2, supérieure à l'épaisseur du guide d'onde sur les figures 3 et 4). Sur la figure 4, l'épaisseur h des motifs correspond à l'épaisseur de la couche de guidage de la lumière 12 (le guide d'onde présentant une épaisseur plus faible que celle de la couche de guidage de la lumière 12) tandis que sur la figure 3, l'épaisseur h des motifs est supérieure à l'épaisseur de la couche de guidage de la lumière 12. Dans la variante de réalisation de la figure 3, les motifs sont constitués du matériau de la couche de guidage de la lumière et du matériau d'une couche supplémentaire rajoutée à la couche de guidage de la lumière. Cette couche supplémentaire est par exemple en silicium amorphe déposé ou en silicium cristallin, ou en tout autre matériau à fort indice par contraste avec celui de l'air ou du matériau venant remplir les tranchées.

La structure de collimation peut ainsi être fabriquée au moyen d'étapes de fabrication (lithographie/gravure) standards, c'est-à-dire donnant lieu à des structurations « numériques » (figure 5a, où un 1 numérique correspond à une gravure d'une tranchée et un 0 numérique correspond à une absence de gravure venant définir un motif d'épaisseur invariable) par opposition à des structures de collimation de l'état de l'art qui nécessitent une structuration « analogique » permettant de définir des motifs d'épaisseur variable, par exemple un dioptre sphérique (figure 5b) ou des crêtes d'inclinaisons variables (figure 5c). Une telle structuration analogique est généralement obtenue par une technique de lithographie par fluage de la résine ou par lithographie dite « Gray tone » qui présente l'inconvénient d'être difficile à calibrer pour obtenir les formes analogiques souhaitées.

On relèvera par ailleurs que la formation de la lentille numérique dans la couche de guidage de la lumière à fort indice ne nécessite qu'une faible épaisseur de motifs. Ainsi, lorsque les motifs sont réalisés dans une couche de silicium d'indice 3.5 et que les tranchées sont laissées à l'air, l'épaisseur des motifs est au minimum d'environ $1\mu m$. Avec des motifs réalisés dans une couche d'encapsulation en SiO2 d'indice 1.5, les tranchées étant laissées à l'air, cette épaisseur minimale est d'environ $7\mu m$. Avec des motifs cylindriques de diamètre 100nm, les motifs présentent un rapport longueur-diamètre de 10 lorsqu'ils sont réalisés dans la couche de guidage de la lumière et un rapport longueur-diamètre de 70 lorsqu'ils sont réalisés dans la couche d'encapsulation. Or un tel rapport de 70 est en pratique impossible à atteindre à ce jour par gravure. Sans compter que des motifs de si petite taille (diamètre de 100nm) sont, avec les outils de fabrication de la microélectronique, difficiles à graver dans une couche d'encapsulation du fait de sa mauvaise planéité.

Une telle lentille numérique est en outre avantageuse en ce qu'elle peut être réalisée dans la couche de guidage de la lumière en même temps qu'un coupleur vertical de type réseau de couplage surfacique, par photolithographie et gravure. Toute erreur d'alignement entre ces composants est alors éliminée, à la différence d'une formation de la lentille sur la surface de la puce, après fabrication et structuration de la couche de guidage de la lumière pour y former notamment un coupleur vertical, qui est elle sujette à des erreurs d'alignement venant en dégrader les performances.

L'invention permet de bénéficier d'une longueur de focale importante du fait du repliement du trajet optique entre le coupleur vertical et la structure de collimation (cette focale est au maximum d'environ deux fois l'épaisseur du substrat 10). Elle permet également de réaliser la structure de collimation avant la formation des couches de métal de la puce photonique, cette structure étant réalisée au niveau de la couche de guidage de la lumière, c"est à dire au niveau des composants de la puce photonique.

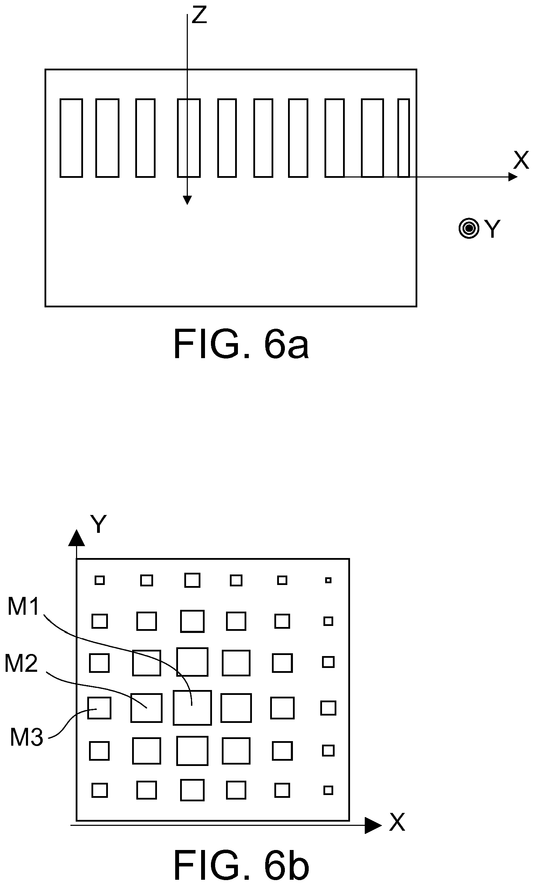

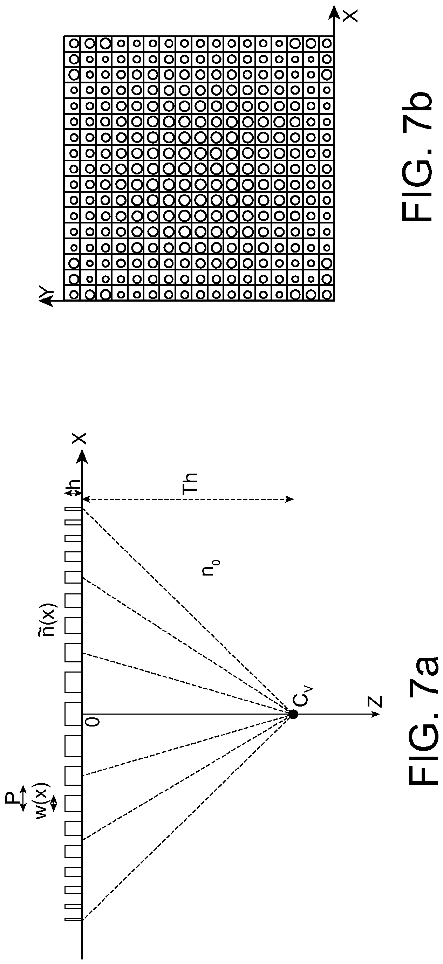

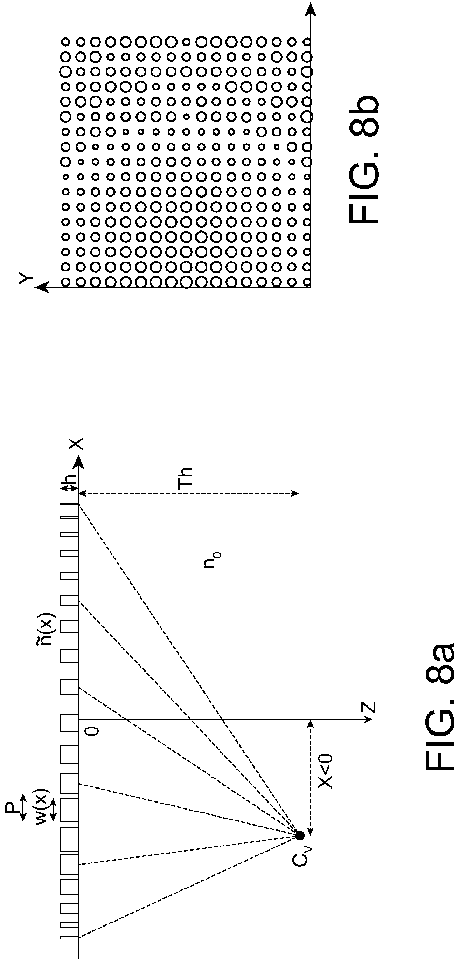

Reprenant le repère (xyz) de la figure 1 et en référence à la figure 6a, chaque tranchée présente une profondeur selon la direction orthogonale aux faces avant et arrière (direction z). Les tranchées séparent des motifs d'épaisseur invariable qui peuvent former un réseau bidimensionnel. Comme représenté en figures 6b, 7b et 8b, les motifs peuvent former un réseau matriciel de plots de section (dans le plan (xy)) carrée ou rectangulaire (figure 6c), ou circulaire (figures 7b et 8b). Les motifs peuvent notamment être disposés en symétrie circulaire autour d'un axe de symétrie non nécessairement confondu avec l'axe médian de la structure de collimation passant en son centre, les motifs équidistants de l'axe de symétrie étant de taille identique. Ces dernières formes, contrairement à des anneaux, permettent une insensibilité à la polarisation. En effet le champ électrique de l'onde optique peut prendre n'importe quelle orientation dans le plan (xy) et les indices vus par l'onde, à l'échelle de la longueur d'onde, sont identiques quelle que soit l'orientation du champ électrique..

La structuration de la couche cœur 1 consiste à y former une pluralité de tranchées T1-T4 d'indice de réfraction inférieur à l'indice de réfraction des motifs. De telle manière, la structure de collimation forme une structure à pseudo-gradient d'indice de réfraction à même de collimater vers l'extérieur un front d'onde courbe incident depuis le coupleur vertical (et vice-versa de générer un déphasage courbe d'un front d'onde plan incident depuis l'extérieur). Plus particulièrement, la couche de guidage de la lumière est formée dans un matériau cœur d'indice de réfraction nc dans lequel sont formés les motifs, et les tranchées sont laissées à l'air ou remplies d'un matériau de remplissage d'indice de réfraction nr inférieur à l'indice de réfraction nc du matériau cœur, par exemple en $SiO_2$. La différence entre les indices de réfraction du cœur et des tranchées est de préférence au moins égal à 0,2.

Par pseudo-gradient d'indice, on entend dans le cadre de l'invention que la structure de collimation ne comporte pas un véritable profil de variation d'indice de réfraction du matériau cœur comme c'est le cas des structures dite « graded-index », mais qu'elle en présente les mêmes propriétés. Ainsi lors de son passage dans la structure de collimation, la lumière rencontre l'équivalent d'une lentille.

Les tranchées peuvent être agencées périodiquement, la largeur des tranchées séparant deux motifs contigus étant modulée d'une tranchée à l'autre. De telle manière, le facteur de remplissage en matériau de la couche cœur (qui définit l'indice de réfraction local) évolue le long de la structure de collimation.

Prenant l'exemple d'un réseau matriciel de plots cylindriques, ce réseau comprend un ensemble de cellules élémentaires carrées de même taille, on retrouve un plot par cellule et la surface des plots est modulée d'une cellule à l'autre. Le facteur de remplissage peut alors s'exprimer comme le rapport entre la surface d'un plot et la surface de la cellule élémentaire. Avec une cellule élémentaire carrée de côté 500nm, le diamètre de plots peut évoluer entre 20nm et 480nm.

On relèvera que par rapport à une lentille analogique (classique ou de Fresnel), la structure proposée présente des réflexions inférieures. En effet, l'indice moyen est largement diminué.

Dans un mode de réalisation possible de l'invention, la structure de collimation est configurée pour extraire la lumière la traversant depuis le coupleur vertical selon la normale à la face avant ou arrière de la puce. On a vu précédemment que dans certaines configurations le coupleur vertical permet de passer d'une propagation guidée dans le plan de la puce à une propagation quasi-verticale formant un angle avec la normale aux faces avant et arrière de la puce. Dans le cadre de ce mode de réalisation, la structure de collimation permet de redresser le faisceau de sorte que le faisceau en sortie de la face avant ou arrière de la puce photonique est perpendiculaire aux faces avant et arrière de la puce (figures 8a et 8b discutées ci-après).

Le fait d'extraire grâce à l'invention un faisceau collimaté de taille élargie permet d'augmenter la tolérance d'alignement suivant les axes x,y de la puce avec une pièce d'interface opto-mécanique posée sur une face de la puce. Mais la tolérance angulaire de réception est réduite. En venant redresser le faisceau pour qu'il présente un angle de 90° avec la face de la puce, le couplage avec la pièce d'interface est facilité. Ainsi la pièce peut être posée sur la surface plane de la puce, de façon rigoureusement perpendiculaire à elle. La problématique de sensibilité angulaire de l'alignement est ainsi complètement résolue, puisque la pièce opto-mécanique, en contact avec la face F1 de la puce, est rigoureusement perpendiculaire à la puce, sans possible écartement angulaire par rapport à l'axe z.

Les figures 7a-7b illustrent le dimensionnement d'une structure de collimation symétrique et disposée à la verticale du coupleur vertical 122 représenté par le point Cv sur l'axe z (cas où $\Theta1 = \Theta2 = 0$). Les figures 8a-8b illustrent le dimensionnement d'une structure de collimation asymétrique et décalée de $X = Th \times \tan \Theta2$ par rapport au coupleur vertical 122 et permettant de redresser le faisceau collimaté extrait du coupleur 122. Non représenté ici, il est bien sûr possible d'extraire un faisceau collimaté non vertical ($\Theta2 \neq 0$) sans le redresser : une structure de collimation symétrique est alors utilisée, son centre étant décalé de $X = Th \times \tan \Theta2$ par rapport au coupleur vertical 122. Ces structures de collimation peuvent être intégrées dans une puce selon l'invention, conforme au mode de réalisation d'un réseau bidimensionnel de plots cylindriques insensible à la polarisation.

Dans le cadre de l'invention, avec les repliements du trajet optique illustrés sur les figures 1 à 4 qui imposent à la lumière deux passages par le substrat, le décalage est alors de $2 \times Th \times \tan \Theta2$ et les équations suivantes doivent être adaptées en conséquence. La lentille présente un axe médian perpendiculaire au plan x,y et passant par son centre. La projection orthogonale, sur le plan x, y, du centre du coupleur vertical est alors distante du centre de la lentille d'un décalage approximé à $2 \times Th \times \tan \Theta2$. En l'absence de redressement, la structure de collimation peut présenter une symétrie circulaire autour d'un axe de symétrie confondu avec son axe médian. En présence de redressement, la structure de collimation peut présenter une symétrie circulaire autour d'un axe de symétrie distant de $2 \times Th \times \tan \Theta2$ de son axe médian (l'axe de symétrie passe ainsi par le centre du coupleur vertical). Bien entendu, toute variation d'angle intermédiaire entre l'absence et la présence d'un redressement peut être réalisée en décalant le centre de symétrie circulaire de la lentille.

La structure de collimation est configurée pour générer un déphasage courbe d'un front d'onde plan incident depuis l'extérieur de la puce, déphasage tel que les rayons sont, après traversée de la structure de collimation, tous en phase au point focal de la structure de la collimation, le point focal étant le coupleur vertical (assimilé à un point au regard de la distance focale Th qui correspond globalement à deux fois l'épaisseur du substrat 10). Réciproquement, la structure de collimation vient générer un front d'onde plan à partir d'un faisceau divergent issu du coupleur vertical. Les figures 7a et 8a sont des vues des motifs selon une coupe parallèle au plan (xz) tandis que les figures 7b et 8b sont des vues des motifs selon une coupe parallèle au plan (xy).

Le diamètre des plots est calculé suivant la méthodologie présentée ci-dessous.

Dans l'exemple des figures 7a et 7b où le point focal est sur l'axe médian z de la structure de collimation, et d'un remplissage des tranchées par du SiO$_2$, cette configuration traduit par :

$$\frac{2\pi}{\lambda} \tilde{n}(x,y)h + \frac{2\pi}{\lambda} n_0 \sqrt{F^2 + x^2 + y^2} = \frac{2\pi}{\lambda} \tilde{n}(0)h + \frac{2\pi}{\lambda} n_0 F$$

Soit $\tilde{n}(x,y) = \tilde{n}(0) - \dfrac{n_0\sqrt{F^2+x^2+y^2}-n_0 F}{h}$, où $\tilde{n}(x,y)$ représente l'indice moyen de la lentille à la position (x,y), liée au facteur de remplissage de silicium, h l'épaisseur des motifs de silicium, *Th* correspond à 2 fois l'épaisseur du substrat(par exemple $2 \times 775\mu m$ pour un substrat SOI de 300mm de diamètre), $\lambda$ la longueur d'onde centrale du faisceau lumineux et $n_0$ l'indice du matériau composant le substrat 10.

L'indice moyen $\tilde{n}(x)$ est lié au facteur de remplissage de silicium $f_{Si}(x)$, par:

$$\tilde{n}(x) = \sqrt{f_{Si}(x) * n_{Si}^2 + (1 - f_{Si}(x)) * n_{SiO_2}^2}$$

, avec $n_{Si}$ et $n_{SiO_2}$ les indices respectifs du Silicium et du SiO$_2$.

On en déduit l'évolution du facteur de remplissage de silicium :

$$f_{Si}(x) = \frac{\left( \sqrt{f_{Si}(0) * n_{Si}^2 + (1 - f_{Si}(0)) * n_{SiO_2}^2} - \frac{n_0\sqrt{F^2 + x^2 + y^2} - n_0 F}{h} \right)^2 - n_{SiO_2}^2}{(n_{Si}^2 - n_{SiO_2}^2)}$$

Si on considère que la structure de collimation s'apparente à un réseau pseudopériodique, de pseudopériode P (position des centres des plots) et dont le diamètre variable des plots $W_{Si}(x, y)$, les motifs présentent un diamètre défini selon une série $W_{Si}(n, p)$, vérifiant, pour $n \in [-N ; N]$ et $p \in [-N ; N]$ :

$$W_{Si}(n,p) = 2P . \sqrt{\frac{\left( \sqrt{\frac{\pi W_{Si}(0)^2 * n_{Si}^2 + (4P^2 - \pi W_{Si}(0)^2) * n_{SiO_2}^2}{4P^2}} - n_0 \frac{\sqrt{F^2 + (nP)^2 + (pP)^2} - F}{h} \right)^2 - n_{SiO_2}^2}{\pi(n_{Si}^2 - n_{SiO_2}^2)}} \quad (1)$$

Dans l'exemple des figures 8a et 8b le point focal de la structure de collimation est décalé de l'axe médian z d'une distance X = Th x tan Θ2. La structure de collimation est calculée comme suit :

$$\frac{2\pi}{\lambda}\tilde{n}(x,y)h + \frac{2\pi}{\lambda}n_0\sqrt{F^2 + (x - X)^2 + y^2} = \frac{2\pi}{\lambda}\tilde{n}(0)h + \frac{2\pi}{\lambda}n_0\sqrt{F^2 + X^2}$$

Soit, $\tilde{n}(x) = \tilde{n}(0) - n_0 \frac{\sqrt{F^2 + (x-X)^2 + y^2} - \sqrt{F^2 + X^2}}{h}$ . Sachant que :

$\tilde{n}(x) = \sqrt{f_{Si}(x) * n_{Si}^2 + (1 - f_{Si}(x)) * n_{SiO_2}^2}$ On en déduit :

$$f_{Si}(x)$$

$$= \frac{\left( \sqrt{f_{Si}(0) * n_{Si}^2 + (1 - f_{Si}(0)) * n_{SiO_2}^2} - n_0 \frac{\sqrt{F^2 + (x - X)^2 + y^2} - \sqrt{F^2 + X^2}}{h} \right)^2 - n_{SiO_2}^2}{(n_{Si}^2 - n_{SiO_2}^2)}$$

Si on considère que la structure de collimation s'apparente à un réseau pseudopériodique, de pseudopériode P (position des centres des plots) et dont le diamètre variable des plots $W_{Si}(x, y)$, les motifs présentent un diamètre défini selon une série $W_{Si}(n, p)$, vérifiant, pour $n \in [-N ; N]$ et $p \in [-N ; N]$ :

$$W_{Si}(n,p) = 2P . \sqrt{\frac{\left( \sqrt{\frac{\pi W_{Si}(0)^2 * n_{Si}^2 + (4P^2 - \pi W_{Si}(0)^2) * n_{SiO_2}^2}{4P^2}} - n_0 \frac{\sqrt{F^2 + (nP - X)^2 + (pP)^2} - \sqrt{F^2 + X^2}}{h} \right)^2 - n_{SiO_2}^2}{\pi(n_{Si}^2 - n_{SiO_2}^2)}} \quad (2)$$

Pour une structure de collimation sans redressement, c'est le motif central qui possède la plus grande largeur, donc l'on peut fixer $W_{Si}(0) = P - cd\_min$, avec $cd\_min$ la largeur minimale d'une tranchée techniquement réalisable par gravure. Une telle structure de collimation est symétrique.

Pour une structure de collimation assurant le redressement du faisceau, (cas de la figure 8b), on peut trouver la position du motif le plus grand en dérivant l'équation (2) par rapport à n : c'est le motif d'abscisse X qui est le plus grand (celui à l'aplomb du point focal). Cette structure de collimation est donc asymétrique.

Pour cette structure de collimation asymétrique, on peut réécrire les équations, non pas en fonction de $W_{Si}(0)$, mais en fonction de $W_{Si}(X)$ :

$$\frac{2\pi}{\lambda}\tilde{n}(x,y)h + \frac{2\pi}{\lambda}n_0\sqrt{F^2+(x-X)^2+y^2} = \frac{2\pi}{\lambda}\tilde{n}(X,0)h + \frac{2\pi}{\lambda}n_0 F$$

$$\text{Soit}: \tilde{n}(x,y) = \tilde{n}(X,0) + \frac{n_0}{h}\left[F - \sqrt{F^2+(x-X)^2+y^2}\right]$$

$$f_{Si}(x)$$

$$= \frac{\left[\sqrt{f_{Si}(X)*n_{Si}^2 + \left(1-f_{Si}(X)\right)*n_{SiO_2}^2} + \frac{n_0}{h}\left[F-\sqrt{F^2+(x-X)^2+y^2}\right]\right]^2 - n_{SiO_2}^2}{\left(n_{Si}^2-n_{SiO_2}^2\right)}$$

Soit:

$$W_{Si}(n,p) = 2P.\sqrt{\frac{\left[\sqrt{\frac{\pi W_{Si}(0)^2*n_{Si}^2+(4P^2-\pi W_{Si}(0)^2)*n_{SiO_2}^2}{4P^2}} - n_0\frac{\left[\sqrt{F^2+(nP-X)^2+(pP)^2}-F\right]}{h}\right]^2 - n_{SiO_2}^2}{\pi\left(n_{Si}^2-n_{SiO_2}^2\right)}}$$

Lorsque X<D/2 avec D la largeur de la structure de collimation selon l'axe x, le motif le plus grand est celui d'abscisse X : $W_{Si-max} = W_{Si}(X) = P - cd\_min$.
On en déduit :

$$W_{Si}(n,p) = 2P.\sqrt{\frac{\left[\sqrt{\frac{\pi(P-cd\_min)^2*n_{Si}^2+(4P^2-\pi(P-cd\_min)^2)*n_{SiO_2}^2}{4P^2}} - n_0\frac{\left[\sqrt{F^2+(nP-X)^2+(pP)^2}-F\right]}{h}\right]^2 - n_{SiO_2}^2}{\pi\left(n_{Si}^2-n_{SiO_2}^2\right)}}$$

$$(3)$$

Il est également possible de déterminer le diamètre minimal $W_{Si-min}$ d'un motif, qui est le diamètre du motif le plus éloigné de l'abscisse X. On a:

$$W_{Si-min}$$

$$= 2P.\sqrt{\frac{\left[\sqrt{\frac{\pi(P-cd\_min)^2*n_{Si}^2+(4P^2-\pi(P-cd\_min)^2)*n_{SiO_2}^2}{4P^2}} - n_0\frac{\left[\sqrt{F^2+(NP+X)^2+(NP)^2}-F\right]}{h}\right]^2 - n_{SiO_2}^2}{\pi\left(n_{Si}^2-n_{SiO_2}^2\right)}}$$

$$= cd\_min$$

Cette dernière équation permet de déterminer l'épaisseur h de gravure minimale permettant de concevoir une structure de collimation techniquement réalisable, c'est-à-dire n'excédant pas cd_min et P-cd_min en diamètre de motifs, pour une largeur de lentille D donnée selon l'axe x:

$$h = n_0 \frac{2P\left[\sqrt{F^2+(NP+X)^2+(NP)^2}-F\right]}{\sqrt{\pi(P-cd\_min)^2*n_{Si}^2+(4P^2-\pi(P-cd\_min)^2)*n_{SiO_2}^2}-\sqrt{\pi cd_{min}^2*\left(n_{Si}^2-n_{SiO_2}^2\right)+4P^2 n_{SiO_2}^2}} \quad (4)$$

Par contre, si X>D/2, alors le motif le plus grand est celui qui est le plus proche de l'abscisse X. Prenant le cas X>0 où le motif le plus grand est celui d'indice N (pour X<0, il suffit de retourner la structure de collimation). On réécrit les équations par rapport à ce motif d'indice N :

$$\frac{2\pi}{\lambda}\tilde{n}(x,y)h + \frac{2\pi}{\lambda}n_0\sqrt{F^2+(x-X)^2+y^2} = \frac{2\pi}{\lambda}\tilde{n}(NP)h + \frac{2\pi}{\lambda}n_0\sqrt{F^2+(NP-X)^2}$$

Cela donne au final :

$$\tilde{n}(x,y) = \tilde{n}(NP) - n_0 \frac{\sqrt{F^2+(x-X)^2+y^2}-\sqrt{F^2+(NP-X)^2}}{h}$$

$$W_{Si}(n,p)$$
$$= 2P.\sqrt{\frac{\left[\sqrt{\frac{\pi W_{Si}(NP)^2*n_{Si}^2+(4P^2-\pi W_{Si}(NP)^2)*n_{SiO_2}^2}{4P^2}}-n_0\frac{\left[\sqrt{F^2+(nP-X)^2+(pP)^2}-\sqrt{F^2+(NP-X)^2}\right]}{h}\right]^2-n_{SiO_2}^2}{\pi\left(n_{Si}^2-n_{SiO_2}^2\right)}}$$

En imposant la plus grande dimension au motif d'indice N, on a :

$$W_{Si}(n,p) =$$
$$2P.\sqrt{\frac{\left[\sqrt{\frac{\pi(P-cd\_min)^2*n_{Si}^2+(4P^2-\pi(P-cd\_min)^2)*n_{SiO_2}^2}{4P^2}}-n_0\frac{\left[\sqrt{F^2+(nP-X)^2+(pP)^2}-\sqrt{F^2+(NP-X)^2}\right]}{h}\right]^2-n_{SiO_2}^2}{\pi\left(n_{Si}^2-n_{SiO_2}^2\right)}} \quad (3bis)$$

Le plot de plus petite dimension est alors d'indice (-N,±N) :

$$W_{Si-min} = 2P.\sqrt{\frac{\left[\sqrt{\frac{\pi(P-cd\_min)^2*n_{Si}^2+(4P^2-\pi(P-cd\_min)^2)*n_{SiO_2}^2}{4P^2}}-n_0\frac{\left[\sqrt{F^2+(NP+X)^2+(NP)^2}-\sqrt{F^2+(NP-X)^2}\right]}{h}\right]^2-n_{SiO_2}^2}{\pi\left(n_{Si}^2-n_{SiO_2}^2\right)}}$$
$$= cd\_min$$

Ce qui nous donne la valeur de h dans ce cas-là :

$$h = n_0 \frac{2P\left[\sqrt{F^2+(NP+X)^2+(NP)^2}-\sqrt{F^2+(NP-X)^2}\right]}{\sqrt{\pi(P-cd\_min)^2*n_{Si}^2+\left(4P^2-\pi(P-cd\_min)^2\right)*n_{SiO_2}^2}-\sqrt{\pi cd_{min}^2*\left(n_{Si}^2-n_{SiO_2}^2\right)+4P^2 n_{SiO_2}^2}}$$
$$(4bis)$$

La procédure de conception de la structure de collimation peut être la suivante :

1) Compte-tenu de P et cd_min, on détermine l'épaisseur nécessaire de la structure de collimation selon les équations (4) ou (4bis), selon que X<D/2 ou X>D/2.

2) On en déduit alors, avec l'épaisseur h trouvée précédemment, le profil exact de la structure de collimation selon les équations (3) ou (3bis), selon que X<D/2 ou X>D/2.

Dans une variante de réalisation, la structure de collimation ne forme pas l'équivalent d'une lentille simple mais l'équivalent d'une lentille de Fresnel. Selon cette approche, on impose une épaisseur h plus faible, et on autorise de plus grands gradients d'indice pour compenser cette faible épaisseur, ces gradients se répétant par des modulos $2\pi$ de phase pour couvrir toute la largeur de la structure de collimation. Selon cette approche :

$$\frac{2\pi}{\lambda}\tilde{n}(x,y)h + \frac{2\pi}{\lambda}n_0\sqrt{F^2 + (x-X)^2 + y^2} = \frac{2\pi}{\lambda}\tilde{n}(X)h + \frac{2\pi}{\lambda}n_0 F[2\pi]$$

$$\text{Soit } \tilde{n}(x,y) = \tilde{n}(X) - \frac{n_0}{h}\left[\sqrt{F^2 + (x-X)^2 + y^2} - F\right] + m\frac{\lambda}{h}, \text{m} \in Z^+$$

Soit

$$f_{Si}(x,y) = \frac{\left[\sqrt{f_{Si}(X)*n_{Si}^2 + (1-f_{Si}(X))*n_{SiO_2}^2} - \frac{n_0}{h}\left[\sqrt{F^2 + (x-X)^2 + y^2} - F\right] + m\frac{\lambda}{h}\right]^2 - n_{SiO_2}^2}{(n_{Si}^2 - n_{SiO_2}^2)}$$

Soit :

$$W_{Si}(n,p) =$$

$$2P.\sqrt{\frac{\left[\sqrt{\frac{\pi(P-cd\_min)^2*n_{Si}^2+(4P^2-\pi(P-cd\_min)^2)*n_{SiO_2}^2}{4P^2}} - n_0\frac{\left[\sqrt{F^2+(nP-X)^2+(pP)^2}-F\right]}{h}+m\frac{\lambda}{h}\right]^2 - n_{SiO_2}^2}{\pi(n_{Si}^2-n_{SiO_2}^2)}} \quad (5)$$

Le terme m permet d'ajouter un incrément à la largeur pour éviter qu'elle n'aille en dessous de cd_min. Cependant, cet incrément ne doit pas faire passer la largeur au-delà de P-cd_min pour avoir le modulo $2\pi$ de phase, ou en-dessous de cd_min respectivement. Cela impose des contraintes sur l'épaisseur minimale de la lentille de Fresnel hmin, pour qu'elle soit techniquement réalisable. Supposons que l'un des motifs ait une largeur de cd_min (limite inférieure). Ce motif a un indice (n', p') qui vérifie :

$$\frac{cd\_min^2\pi(n_{Si}^2 - n_{SiO_2}^2) + 4P^2.n_{SiO_2}^2}{4P^2}$$

$$= \left[\sqrt{\frac{\pi(P-cd\_min)^2*n_{Si}^2 + (4P^2 - \pi(P-cd\_min)^2)*n_{SiO_2}^2}{4P^2}}\right]$$

$$- n_0\frac{\left[\sqrt{F^2 + (nP-X)^2 + (pP)^2} - F\right]}{h}\right]^2$$

Il faut qu'un ajout de $\lambda/h$ dans le carré du terme de droite génère une largeur inférieure à P-cd_min dans l'équation (5), soit :

$$P - cd_{min} \geq 2P. \sqrt{\dfrac{\dfrac{cd\_min^2 \pi\left(n_{Si}^2 - n_{SiO_2}^2\right) + 4P^2 . n_{SiO_2}^2}{4P^2} + \dfrac{\lambda^2}{h_{min}^2} + 2\dfrac{\lambda}{h_{min}} \sqrt{\dfrac{cd\_min^2 \pi\left(n_{Si}^2 - n_{SiO_2}^2\right) + 4P^2 . n_{SiO_2}^2}{4P^2}}}{\pi\left(n_{Si}^2 - n_{SiO_2}^2\right)}}$$

On en déduit donc qu'il y a une contrainte entre la longueur d'onde et l'épaisseur, pour une technologie donnée (P, cdmin), pour que la lentille de Fresnel soit réalisable.

$$\left[P\pi(P - 2cd_{min})\left(n_{Si}^2 - n_{SiO_2}^2\right) - 4P^2 n_{SiO_2}^2\right].h^2 - \left[8P^2\lambda\sqrt{\dfrac{cd\_min^2\pi\left(n_{Si}^2-n_{SiO_2}^2\right)+4P^2.n_{SiO_2}^2}{4P^2}}\right]h - 4P^2\lambda^2 \geq 0$$

hmin correspond donc à la 2ème racine de l'équation afférente de 2nd degré, soit :

$$h_{min} = 2\lambda \dfrac{\sqrt{cd\_min^2\pi\left(n_{Si}^2-n_{SiO_2}^2\right)+4P^2.n_{SiO_2}^2} + \sqrt{\pi\left(n_{Si}^2-n_{SiO_2}^2\right)(P-cd_{min})}}{\pi(P-2cd_{min})\left(n_{Si}^2-n_{SiO_2}^2\right)-4Pn_{SiO_2}^2} \quad (6)$$

La période P ne peut pas excéder λ/2 pour que la structuration se comporte comme un milieu d'indice moyen. En imposant cette contrainte, on peut simplifier l'expression (6), et aboutir à :

$$h_{min} = 2\lambda \dfrac{2\sqrt{cd\_min^2\pi\left(n_{Si}^2 - n_{SiO_2}^2\right) + \lambda^2.n_{SiO_2}^2} + \sqrt{\pi\left(n_{Si}^2 - n_{SiO_2}^2\right)(\lambda - 2cd_{min})}}{\pi(\lambda - 4cd_{min})\left(n_{Si}^2 - n_{SiO_2}^2\right) - 4\lambda n_{SiO_2}^2}$$

Un exemple de dimensionnement de la structure de collimation est le suivant. On utilise un réseau de couplage surfacique en guise de coupleur vertical (Do=9.2$\mu$m), réalisé en technologie photonique silicium, dans un substrat SOI. On fixe également une taille de mode wi = Di/2 (Di = D) en sortie de la structure de collimation, par exemple Di = 80$\mu$m. On cherche une épaisseur des motifs, cylindriques, dans un réseau bidimensionnel à maille constante P, la plus faible possible. On fixe le diamètre minimal d'un motif à 80nm, et on considère une pseudo-période des structures gravées P = 500nm. On utilise un substrat SOI d'épaisseur 775$\mu$m, donc Th = 1550$\mu$m. Avec un angle de sortie du réseau de couplage surfacique $\Theta$1 dans le SiO2 égal à 8°, $\Theta$2 dans le silicium est égal à 3.3° (n$_{Si}$ $\times$ sin ($\Theta$2) = n$_{SiO2}$ $\times$ sin ($\Theta$1) avec n$_{Si}$ = 3.5 et n$_{SiO2}$ = 1.45). Il en découle une longueur de focale dans le substrat d'environ 750$\mu$m. Le centre de la structure de collimation est décalé du centre du coupleur vertical de X = 2 $\times$ Th x tan ($\Theta$2) ~90$\mu$m qui doit être supérieure à Di/2, ce qui est le cas

Avec les équations précédentes, on calcule l'épaisseur minimale des motifs de la structure de collimation dans le cas où elle du type lentille simple ou du type lentille de de Fresnel. Dans l'application numérique retenue, l'épaisseur minimale est de 1.1 $\mu$m pour le cas lentille de Fresnel et de plusieurs $\mu$m pour le cas lentille simple. Puis on calcule les diamètres des motifs à graver pour former la structure de collimation en considérant $W_{Si-min}$=0,08 $\mu$m.

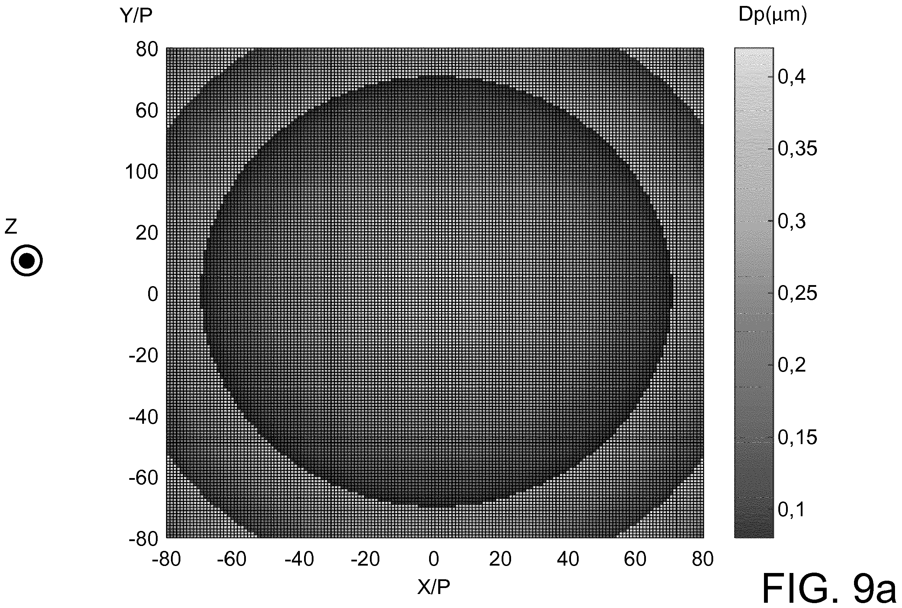

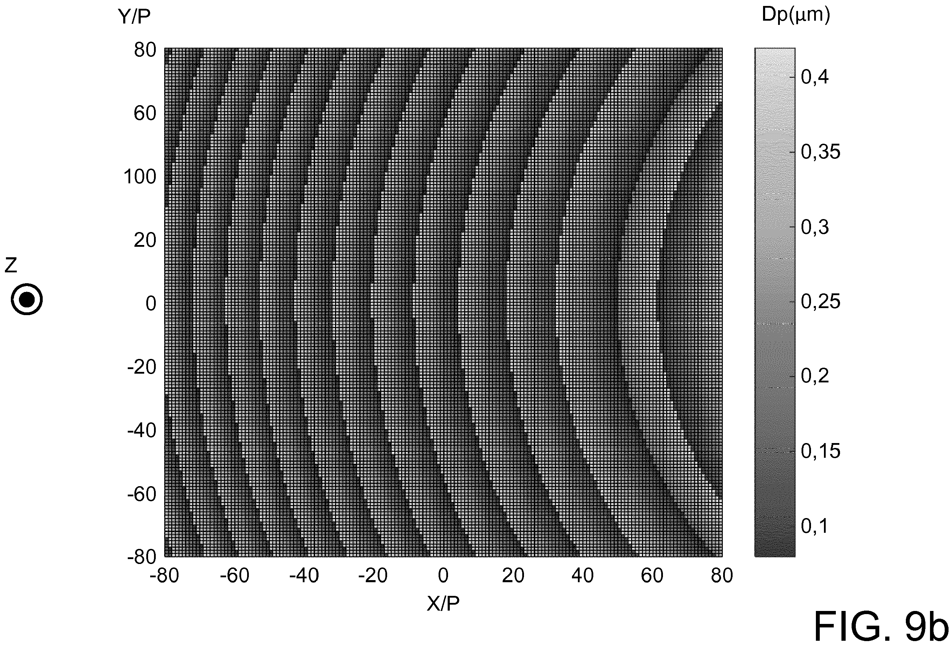

On a représenté sur la figure 9a un exemple de dimensionnement d'une structure de collimation bidimensionnelle ne redressant pas le faisceau lumineux en sortie de puce, et sur la figure 9b un exemple de dimensionnement d'une structure de collimation redressant le faisceau lumineux en sortie de puce. Ces figures représentent plus particulièrement le diamètre Dp des plots cylindriques dans l'application numérique exposée ci-dessus. L'épaisseur des motifs est de 1.1 $\mu$m.

Ces figures 9a et 9b sont relatives à des structures de type lentille de Fresnel. Le diamètre des plots définit l'indice moyen local et ces figures illustrent donc également le pseudo-gradient d'indice de la structure de collimation. On peut également rapprocher le profil de variation du diamètre des plots de la structure de collimation de l'invention du profil géométrique de lentilles analogues.

L'invention n'est pas limitée à la puce photonique précédemment décrite, mais s'étend également à son procédé de fabrication, et notamment à un procédé de fabrication de plusieurs puces collectivement sur une même plaque. Ce procédé comprend la formation d'une structure de collimation 14 au moins en partie dans la couche de guidage de la lumière 12, et la formation d'un agencement d'une ou plusieurs structures réfléchissantes 151, 152 chacune sur l'une des faces avant et arrière, ledit agencement étant réalisé de manière à assurer la propagation de la lumière entre le coupleur vertical et la structure de collimation selon un trajet optique présentant au moins un repliement.

Un exemple de réalisation de ce procédé est le suivant. Le procédé débute par la fourniture d'un substrat SOI présentant une couche d'oxyde enterré 11 intercalée entre une couche de silicium superficielle 12 et un substrat de silicium 10. Le procédé se poursuit par la fabrication des composants photoniques (guide d'onde 121, coupleur vertical 122, modulateur PN, etc.) et des motifs de la structure de collimation 14 par gravure localisée, partielle ou totale, de la couche de silicium superficielle 12

On procède ensuite à la fabrication de la couche d'encapsulation 13. Cette couche peut comprendre les niveaux de métal d'interconnexions électriques de la puce photonique. Elle peut, ou pas, venir combler les tranchées de la structure de collimation. On procède ensuite à la formation de la structure réfléchissante 152 en face arrière, par exemple par dépôt d'une couche métallique. Cette opération peut toutefois être réalisée à un autre moment, par exemple en tout début de processus.

## Revendications

**1.** Puce photonique (1) comprenant une couche de guidage de la lumière (12) supportée par un substrat (10) et recouverte par une couche d'encapsulation (13), la puce photonique présentant une face avant (F1) du côté de la couche d'encapsulation (13) et une face arrière (F2) du côté du substrat (10), la couche de guidage de la lumière incluant une structure de guidage de la lumière (121) comprenant un guide d'onde et optiquement couplée à un coupleur vertical (122) configuré pour recevoir de la lumière depuis le guide d'onde et former un faisceau de lumière dirigé vers l'une des faces avant et arrière,

la puce photonique comportant en outre une structure de collimation (14) et un agencement d'une ou plusieurs structures réfléchissantes (151, 152) chacune sur l'une des faces avant et arrière, ledit agencement étant réalisé de manière à assurer la propagation de la lumière entre le coupleur vertical et la structure de collimation selon un trajet optique présentant au moins un repliement

la puce photonique étant **caractérisée en ce que** la structure de collimation est formée au moins en partie dans la couche de guidage de la lumière (12).

**2.** Puce photonique selon la revendication 1, dans laquelle le coupleur vertical (122) est un réseau de couplage surfacique.

**3.** Puce photonique selon l'une des revendications 1 et 2, dans laquelle la structure de collimation (14) comprend une pluralité de tranchées (T1, T2, T3) pratiquées dans la couche de guidage de la lumière, les tranchées délimitant un ensemble de motifs (M1, M2, M3) et chaque motif présentant, dans une direction orthogonale aux faces avant et arrière, une épaisseur invariable.

**4.** Puce photonique selon la revendication 3, dans laquelle les motifs ont tous la même épaisseur.

**5.** Puce photonique selon l'une des revendications 3 et 4, dans laquelle l'épaisseur d'un motif est au moins égale à l'épaisseur de la couche de guidage de la lumière.

**6.** Puce photonique selon l'une des revendications 3 à 5, dans laquelle les motifs forment un réseau bidimensionnel périodique et dans laquelle les dimensions des motifs sont modulées d'une période à l'autre.

**7.** Puce photonique selon l'une des revendications 3 à 6, dans laquelle la couche de guidage de la lumière est formée dans un matériau cœur d'indice de réfraction nc, et les tranchées sont laissées à l'air ou remplies d'un matériau de remplissage d'indice de réfaction nr inférieur à l'indice de réfraction nc du matériau cœur.

**8.** Puce photonique selon l'une des revendications 3 à 7, dans laquelle le substrat présente une épaisseur Th, le faisceau de lumière incident sur la structure de collimation depuis le coupleur vertical fait un angle $\Theta 2$ avec un axe perpendiculaire aux faces avant et arrière et la structure de collimation présente un centre et un axe médian orthogonal aux face avant et arrière passant par son centre, l'axe médian de la lentille et un axe orthogonal aux face avant at arrière passant par le centre du coupleur vertical étant décalés d'une distance $2 \times Th*tan \Theta 2$.

**9.** Puce photonique selon l'une des revendications 1 à 8, dans laquelle la structure de collimation (14) est configurée pour extraire la lumière la traversant depuis le coupleur vertical selon la normale à la face avant ou arrière de la puce.

10. Puce photonique selon l'une des revendications 1 à 9, dans laquelle le substrat (10) est en silicium, la couche de guidage de la lumière (12) repose sur une couche en matériau diélectrique (11), et une couche antireflet est interposée entre le substrat (10) et la couche en matériau diélectrique (11).

11. Procédé de fabrication d'une puce photonique (1) comprenant une couche de guidage de la lumière (12) supportée par un substrat (10) et recouverte par une couche d'encapsulation (13), la puce photonique présentant une face avant (F1) du côté de la couche d'encapsulation (13) et une face arrière (F2) du côté du substrat (10), la couche de guidage de la lumière incluant une structure de guidage de la lumière (121) comprenant un guide d'onde et optiquement

couplée à un coupleur vertical (122) configuré pour recevoir de la lumière depuis le guide d'onde et former un faisceau de lumière dirigé vers l'une des faces avant et arrière,
le procédé comprenant la formation d'une structure de collimation (14) et la formation d'un agencement d'une ou plusieurs structures réfléchissantes (151, 152) chacune sur l'une des faces avant et arrière, ledit agencement étant réalisé de manière à assurer la propagation de la lumière entre le coupleur vertical et la structure de collimation selon un trajet optique présentant au moins un repliement,
le procédé étant **caractérisé en ce que** la structure de collimation est formée au moins en partie dans la couche de guidage de la lumière.

**Patentansprüche**

1. Photonen-Chip (1), eine Lichtführungsschicht (12) umfassend, die von einem Substrat (10) getragen und von einer Verkapselungsschicht (13) bedeckt ist, wobei der Photonen-Chip eine Vorderfläche (F1) auf der Seite der Verkapselungsschicht (13) und eine Hinterfläche (F2) auf der Seite des Substrats (10) aufweist, wobei die Lichtführungsschicht eine Lichtführungsstruktur (121) einschließt, die einen Wellenleiter umfasst und optisch mit einem vertikalen Koppler (122) gekoppelt ist, konfiguriert, um Licht vom Wellenleiter zu empfangen und einen Lichtstrahl zu bilden, der zu einer der Vorder- und Hinterflächen gerichtet ist,

wobei der Photonen-Chip ferner eine Kollimatorstruktur (14) beinhaltet und eine Anordnung einer oder mehrerer reflektierender Strukturen (151, 152) auf jeweils einer der Vorder- und Hinterflächen, wobei die Anordnung so ausgeführt ist, dass die Lichtausbreitung zwischen dem vertikalen Koppler und der Kollimatorstruktur entlang einem optischen Pfad gewährleistet ist, der mindestens eine Überlappung aufweist,
wobei der Photonen-Chip **dadurch gekennzeichnet ist, dass** die Kollimatorstruktur mindestens teilweise in der Lichtführungsschicht (12) gebildet ist.

2. Photonen-Chip nach Anspruch 1, wobei der vertikale Koppler (122) ein Oberflächenkopplungsnetz ist.

3. Photonen-Chip nach einem der Ansprüche 1 und 2, wobei die Kollimatorstruktur (14) eine Vielzahl von Schneisen (T1, T2, T3) umfasst, die in der Lichtführungsschicht eingebracht sind, wobei die Schneisen eine Einheit von Mustern (M1, M2, M3) eingrenzen und jedes Muster eine unveränderliche Dicke aufweist in einer orthogonalen Richtung zu den Vorder- und Hinterflächen.

4. Photonen-Chip nach Anspruch 3, wobei alle Muster die gleiche Dicke haben.

5. Photonen-Chip nach einem der Ansprüche 3 und 4, wobei die Dicke eines Musters mindestens gleich der Dicke der Lichtführungsschicht ist.

6. Photonen-Chip nach einem der Ansprüche 3 bis 5, wobei die Muster ein periodisches zweidimensionales Netzwerk bilden und wobei die Abmessungen der Muster von einer Periode zur anderen moduliert werden.

7. Photonen-Chip nach einem der Ansprüche 3 bis 6, wobei die Lichtführungsschicht aus einem Kernmaterial mit dem Brechungsindex nc gebildet ist und die Schneisen frei belassen oder mit einem Füllmaterial mit dem Brechungsindex nr gefüllt sind, der kleiner ist als der Brechungsindex nc des Kernmaterials.

8. Photonen-Chip nach einem der Ansprüche 3 bis 7, wobei das Substrat eine Dicke Th aufweist, wobei der Lichtstrahl, der vom vertikalen Koppler auf die Kollimatorstruktur einfällt, einen Winkel $\Theta 2$ bildet mit einer Achse senkrecht zu den Vorder- und Hinterflächen und die Kollimatorstruktur ein Zentrum und eine Mediale Achse orthogonale zur Vorder- und Hinterfläche aufweist, die durch ihr Zentrum verläuft, wobei die Mediale Achse der Linse und eine Achse orthogonal zur Vorder- und Hinterfläche durch das Zentrum des vertikalen Kopplers verlaufen und um einen Abstand 2×Th*tan Θ2 versetzt sind.

9. Photonen-Chip nach einem der Ansprüche 1 bis 8, wobei die Kollimatorstruktur (14) konfiguriert ist, um das durch sie hindurchströmende Licht vom vertikalen Koppler entlang der Normalen an der Vorder- oder Hinterfläche des Chips zu extrahieren.

10. Photonen-Chip nach einem der Ansprüche 1 bis 9, wobei das Substrat (10) aus Silizium besteht, die Lichtführungsschicht (12) auf einer Schicht aus dielektrischem Material (11) aufliegt und eine Antireflexionsschicht zwischen dem Substrat (10) und der Schicht aus dielektrischem Material (11) angeordnet ist.

11. Verfahren zur Herstellung eines Photonen-Chips (1), eine Lichtführungsschicht (12) umfassend, die von einem Substrat (10) getragen und von einer Verkapselungsschicht (13) bedeckt ist, wobei der Photonen-Chip eine Vorderfläche (F1) auf der Seite der Verkapselungsschicht (13) und eine Hinterfläche (F2) auf der Seite des Substrats (10) aufweist, wobei die Lichtführungsschicht eine Lichtführungsstruktur (121) einschließt, die einen Wellenleiter umfasst und optisch mit einem vertikalen Koppler (122) gekoppelt ist, konfiguriert, um Licht vom Wellenleiter zu empfangen und einen Lichtstrahl zu bilden, der zu einer der Vorder- und Hinterflächen gerichtet ist,

wobei das Verfahren das Bilden einer Kollimatorstruktur (14) umfasst und das Bilden einer Anordnung einer oder mehrerer reflektierender Strukturen (151, 152) auf jeweils einer der Vorder- und Hinterflächen, wobei die Anordnung so ausgeführt ist, dass die Lichtausbreitung zwischen dem vertikalen Koppler und der Kollimatorstruktur entlang einem optischen Pfad gewährleistet ist, der mindestens eine Überlappung aufweist,
wobei das Verfahren **dadurch gekennzeichnet ist, dass** die Kollimatorstruktur mindestens teilweise in der Lichtführungsschicht gebildet ist.

**Claims**

1. Photonic chip (1) comprising a light guide layer (12) supported by a substrate (10) and covered with an encapsulation layer (13), the photonic chip having a front face (F1) on the side of the encapsulation layer (13) and a back face (F2) on the side of the substrate (10), the light guide layer including a light guide structure (121) comprising a waveguide and optically coupled to a vertical coupler (122) configured to receive light from the waveguide and to form a light beam directed towards either the front face or the back face, the photonic chip also comprising a collimation structure (14) and an arrangement of one or several reflecting structures (151, 152), each on either the front face or the back face, said arrangement being made so as to propagate light between the vertical coupler and the collimation structure along an optical path with at least one fold, the photonic chip being **characterised in that** the collimation structure is at least partly formed in the light guide layer (12).

2. Photonic chip according to claim 1, wherein the vertical coupler (122) is a surface coupling grating.

3. Photonic chip according to one of claims 1 or 2, wherein the collimation structure (14) comprises a plurality of trenches (T1, T2, T3) formed in the light guide layer, the trenches delimiting a set of patterns (M1, M2, M3) and each pattern having an invariable thickness in a direction orthogonal to the front and back faces.

4. Photonic chip according to claim 3, wherein all the patterns have the same thickness.

5. Photonic chip according to one of claims 3 or 4, wherein the thickness of a pattern is at least equal to the thickness of the light guide layer;

6. Photonic chip according to one of claims 3 to 5, wherein the patterns form a periodic two-dimensional grating in which the dimensions of the patterns are modulated from one period to another.

7. Photonic chip according to one of claims 3 to 6, wherein the light guide layer is formed in a core material with refraction index nc, and the trenches are left containing air or are filled with an infill material with a refraction index nr less than the refraction index nc of the core material.

8. Photonic chip according to one of claims 3 to 7, wherein the substrate has a thickness Th, the incident light beam on the collimation structure from the vertical coupler makes an angle $\Theta 2$ with an axis perpendicular to the front and back faces and the collimation structure has a centre and a median axis orthogonal to the front face and the back face passing through its centre, the median axis of the lens and an axis orthogonal to the front face and the back face passing through the centre of the vertical coupler being offset by a distance $2 \times Th^* tan\ \Theta 2$.

9. Photonic chip according to one of claims 1 to 8, wherein the collimation structure (14) is configured to extract light passing through it from the vertical coupler along the normal to the front or back face of the chip.

10. Photonic chip according to one of claims 1 to 9, wherein the substrate (10) is made of silicon, the light guide layer (12) is supported on a layer made of a dielectric material (11) and an anti-reflection layer is interposed between the substrate (10) and the layer made of a dielectric material (11).

11. Method of fabricating a photonic chip (1) comprising a light guide layer (12) supported by a substrate (10) and covered with an encapsulation layer (13), the photonic chip having a front face (F1) on the side of the encapsulation layer (13) and a back face (F2) on the side of the substrate (10), the light guide layer including a light guide structure (121) comprising a waveguide optically coupled to a vertical coupler (122) configured to receive light from the waveguide and to form a light beam directed towards either the front face or the back face, the method including the formation of a collimation structure (14), and the formation of an arrangement of one or several reflecting structures (151, 152) each on one of the front and back faces, said arrangement being made so as to propagate light between the vertical coupler and the collimation structure along an optical path with at least one fold, the method being **characterised in that** the collimation structure is at least partly formed in the light guide layer.

FIG. 1

FIG. 2

FIG. 3

FIG. 4

T1 M1 T2 M2 T3

## FIG. 5a

## FIG. 5b

## FIG. 5c

FIG. 6a

FIG. 6b

FIG. 7a

FIG. 7b

EP 3 495 861 B1

FIG. 8b

FIG. 8a

FIG. 9a

FIG. 9b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8515217 B2

- US 2002003824 A1

**Littérature non-brevet citée dans la description**

- **XIA CHEN.** Apodized Waveguide Grating Couplers for Efficient Coupling to Optical Fibers. *IEEE PHOTONICS TECHNOLOGY LETTERS,* 01 Août 2010, vol. 22 (15

- **S. BERNABÉ et al.** On-Board Silicon Photonics-Based Transceivers With 1-Tb/s Capacity. *IEEE Transactions on Components, Packaging and Manufacturing Technology,* Juillet 2016, vol. 6 (7
- **SUZUKI.** *Dans JLT,* 15 Janvier 2016, vol. 34 (2